# FASCICULE DE BREVET EUROPEEN

(11) **EP 2 339 628 B1**
(45) Date de publication et mention de la délivrance du brevet: **11.03.2015**
(21) Numéro de dépôt: 10195065.7
(22) Date de dépôt: 15.12.2010
(51) Int. Cl.: H01L 23/544, H01L 23/48, G06K 19/067

(54) **Procédé d'identification d'un circuit intégré et circuits intégrés correspondants**
Identifizierungsverfahren einer integrierten Schaltung und entsprechende integrierte Schaltungen
Integrated circuit identification process and corresponding integrated circuits

(30) Priorité: 22.12.2009 FR 0959355
(43) Date de publication de la demande: 29.06.2011
(73) Titulaire: STMicroelectronics (Rousset) SAS, 13790 Rousset (FR)
(72) Inventeur: Fornara, Pascal, 83910, POURRIERES (FR); Lisart, Mathieu, 13100, AIX EN PROVENCE (FR)
(74) Mandataire: Zapalowicz, Francis

(56) Documents cités:
- WO-A2-2006/055645
- WO-A2-2007/028150
- US-A- 5 434 917
- US-A- 5 787 174
- US-A- 6 018 686
- US-A1- 2009 094 566
- US-B1- 6 830 941

## Description

L'invention concerne les circuits intégrés, et plus particulièrement leur identification, en particulier mais non limitativement pour permettre leur traçabilité.

Le document US 5 787 174 A montre un exemple connu d'identification de circuits intégrés comprenant l'usage d'une antenne.

Selon un mode de mise en oeuvre et de réalisation, il est proposé un procédé d'identification d'un circuit intégré permettant une identification aisée, non invasive, c'est-à-dire ne détruisant pas le circuit intégré, et permettant de retrouver un code d'identification logé de façon confidentielle dans le circuit intégré.

Selon un mode de mise en oeuvre et de réalisation, le code d'identification est basé sur des lignes métalliques classiques, par exemple réalisées dans la partie d'interconnexion du circuit intégré, et l'identification comporte la détection de traces électromagnétiques provoquées par des variations de courants circulant le long de ces lignes métalliques ou par des variations de tensions générées sur ces lignes métalliques, les caractéristiques de ces variations de courants ou de tensions étant déterminées par des données stockées de façon secrète ou à tout le moins de façon difficilement détectable, lors de la personnalisation électrique du circuit intégré, dans un moyen de stockage, par exemple un moyen de stockage du type non volatil et électriquement programmable et effaçable (par exemple des points-mémoires EEPROM).

Selon un aspect, qui est revendiqué dans la revendication 1, il est ainsi proposé un procédé d'identification d'un circuit intégré comprenant une production d'un champ électromagnétique par un réseau électriquement conducteur réalisé au sein du circuit intégré et parcouru par des courants électriques transitoires ou soumis à des tensions transitoires (ou variations de tensions) dont les caractéristiques dépendent de la valeur d'un mot numérique, formant un code d'identification du circuit intégré, et stocké de façon secrète dans une mémoire non volatile, et une analyse du champ électromagnétique produit de façon à retrouver ou non ledit code d'identification.

Le stockage de façon secrète ou à tout le moins difficilement détectable dans une mémoire non volatile peut être obtenu par exemple par un stockage dans une mémoire morte protégée ou bien une mémoire du type EEPROM ou bien une mémoire du type FLASH.

Selon une variante, le réseau électriquement conducteur comporte au moins une paire de moyens électriquement conducteurs, par exemple au moins une paire de lignes métalliques, associée à un bit du mot numérique ; les caractéristiques des courants transitoires comportent le sens de circulation du courant transitoire dans un moyen électriquement conducteur ; on fait alors circuler dans les deux moyens électriquement conducteurs de ladite paire deux courants transitoires de même sens ou de sens opposé en fonction de la valeur du bit, et on analyse le champ magnétique produit au dessus de chacun des moyens électriquement conducteurs et entre les deux moyens électriquement conducteurs.

Cette analyse permet de déterminer si la valeur logique du bit est égale à 1 ou à 0.

En général, le réseau électriquement conducteur comporte plusieurs paires de moyens électriquement conducteurs mutuellement espacées d'une distance supérieure à la surface d'analyse d'un moyen d'analyse de champ magnétique par exemple une sonde équipée d'une boucle formant antenne accordée avec l'antenne formée par les paires de moyens électriquement conducteurs. En pratique, cette distance est bien supérieure au diamètre de la boucle de la sonde magnétique. Chaque paire est associée à un bit du mot numérique et on fait circuler dans les deux moyens électriquement conducteurs de chaque paire deux courants transitoires de sens opposés ou de même sens en fonction de la valeur du bit associé à ladite paire, et on analyse le champ magnétique produit au dessus de chacun des moyens électriquement conducteurs et entre les deux moyens électriquement conducteurs de chaque paire, avec ledit moyen d'analyse.

Selon une autre variante, le réseau électriquement conducteur comporte au moins un moyen électriquement conducteur, par exemple une ligne métallique, associé à un bit du mot numérique, les caractéristiques des tensions transitoires comportant une génération ou une absence de génération d'une tension transitoire ou variation de tension dans un moyen électriquement conducteur ; on génère alors ou non dans le moyen électriquement conducteur une variation de tension en fonction de la valeur du bit, et on détecte la présence éventuelle d'un champ électrique produit au dessus du moyen électriquement conducteur.

Cette présence du champ électrique peut être détectée par couplage capacitif entre la ligne métallique et la sonde d'analyse.

Là encore, selon un mode de mise en oeuvre de cette variante, le réseau électriquement conducteur comporte généralement plusieurs moyens électriquement conducteurs mutuellement espacés d'une distance supérieure à la surface d'analyse d'un moyen d'analyse du champ électrique, chaque moyen électriquement conducteur étant associé à un bit du mot numérique, et on génère ou non dans chaque moyen électriquement conducteur une variation de tension en fonction de la valeur du bit qui lui est associé et on détecte la présence éventuelle d'un champ électrique produit au dessus de chaque moyen électriquement conducteur.

La mémoire non volatile peut être une mémoire morte du type électriquement programmable et effaçable.

Selon un autre aspect, il est proposé un circuit intégré selon la revendication indépendante 10 et un circuit intégré selon la revendication indépendante 14. Des exemples de réalisation privilégiés sont décrits dans les revendications dépendantes 11-13 et 15-19.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre de façon schématique un mode de réalisation d'un circuit intégré selon l'invention,
- la figure 2 illustre plus en détail une partie du circuit intégré de la figure 2,
- les figures 3 à 5 illustrent une première variante de l'invention,
- les figures 6 à 8 illustrent schématiquement des modes de réalisation d'un moyen de stockage non volatil et de moyens de contrôle d'un circuit intégré selon l'invention,
- la figure 9 illustre schématiquement un mode de réalisation d'un banc de mesure selon l'invention, et
- les figures 10 et 11 illustrent schématiquement une autre variante de l'invention.

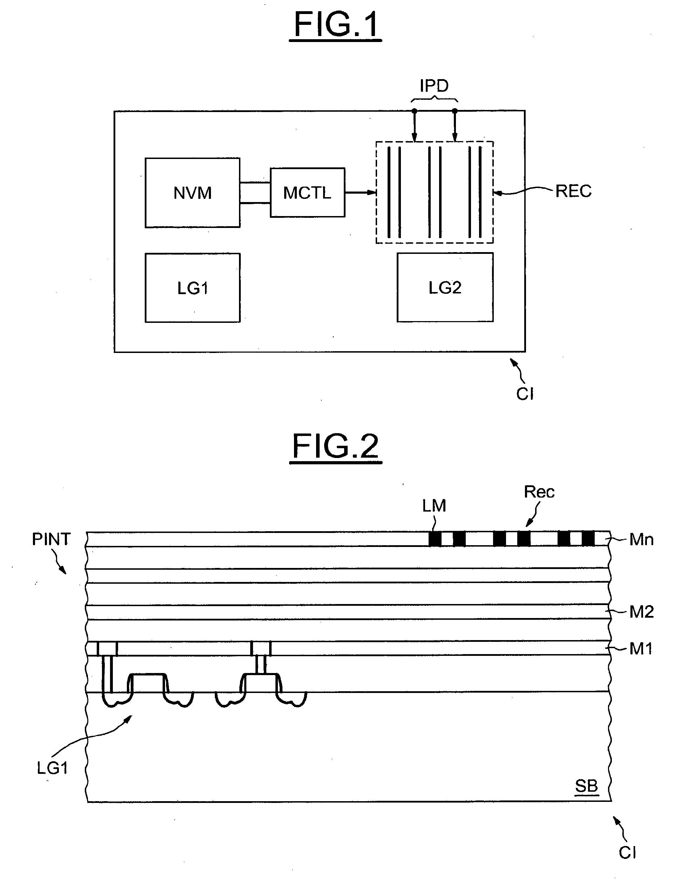

Sur la figure 1, la référence CI désigne un circuit intégré comportant par exemple des blocs logiques LG1, LG2 étant bien entendu que la fonctionnalité de ces blocs n'est pas limitative, ceux-ci pouvant être également remplacés par des blocs de microcontrôleurs par exemple.

Outre ces éléments classiques de circuit intégré, le circuit intégré CI comporte un moyen de mémoire non volatile NVM qui peut être par exemple une mémoire morte protégée ou bien une mémoire du type Flash ou encore une mémoire du type non volatile électriquement programmable et effaçable et bien connue de l'homme du métier sous la dénomination anglosaxonne de « mémoire EEPROM ».

Ce moyen de mémoire non volatile NVM est destiné à contenir de façon secrète ou à tout le moins difficilement détectable un mot numérique dont les valeurs de bits définissent un code d'identification du circuit intégré.

Ce code d'identification est par exemple stocké dans la mémoire NVM lors de la personnalisation électrique du circuit intégré.

Le circuit intégré comporte également un réseau électriquement conducteur REC comportant, dans cet exemple, des paires de moyens électriquement conducteurs tels que des lignes métalliques. Des moyens de contrôle MCTL, dont on verra plus en détail la structure ci-après, sont destinés à générer des courants électriques transitoires (ou variations de courants) dans le réseau électriquement conducteur REC dont les caractéristiques dépendent de la valeur du mot numérique, et donc du code d'identification, stocké dans le moyen de mémoire NVM.

Comme on le verra plus en détail ci-après, les courants électriques transitoires sont produits notamment à partir de signaux de tension en créneaux fournis sur des bornes d'entrée IPD, telles que des bornes d'entrée de test, connectées au réseau électriquement conducteur REC.

Ces courants électriques transitoires vont générer un champ électromagnétique dont les caractéristiques sont reliées aux caractéristiques des courants transitoires et par conséquent au code d'identification. L'analyse de ce champ électromagnétique va permettre l'identification ou la non identification du circuit intégré CI.

Comme illustré sur la figure 2, le réseau électriquement conducteur REC peut être réalisé au dessus du substrat SB dans la partie d'interconnexion PINT du circuit intégré, communément désigné par l'homme du métier sous la dénomination anglosaxonne de « BEOL » (Back-End-Of-Lines), par exemple sur un niveau de métallisation Mn relativement élevé du circuit intégré. Dans l'exemple décrit ici, les moyens électriquement conducteurs composant le réseau REC sont formés de lignes métalliques parallèles, par exemple en cuivre, LM, à réaliser de façon classique et connue en soi. Ces lignes ou pistes métalliques sont classiquement mutuellement séparées par un diélectrique et sont également électriquement isolées des niveaux de métallisation adjacents par un diélectrique.

Bien que ce réseau électriquement conducteur REC puisse être disposé à n'importe quel endroit du circuit intégré, il est préférable de le disposer dans un endroit qui ne se situe pas à la verticale des blocs logiques, de façon à éviter notamment toute interférence potentielle.

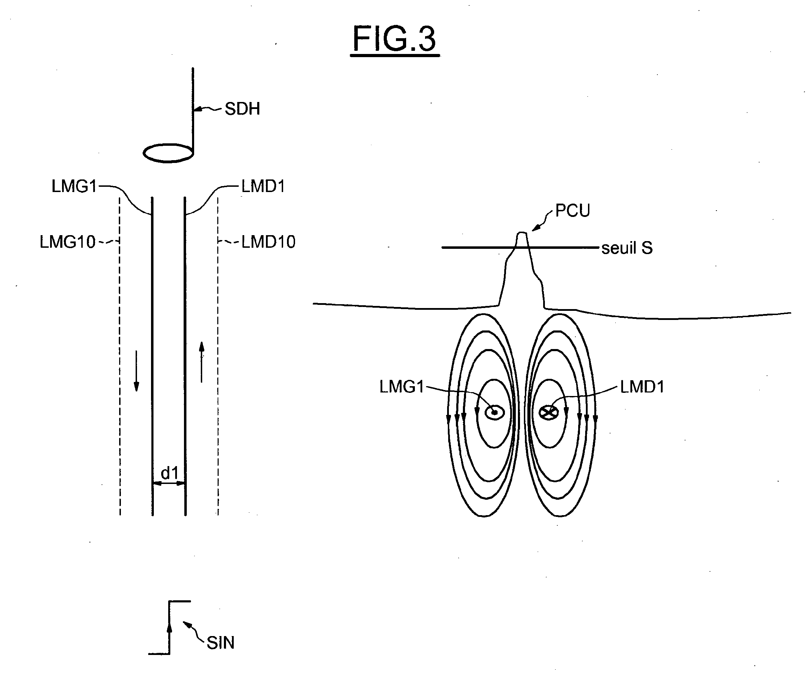

Une première variante de l'invention prévoit d'utiliser (figure 3 notamment) une sonde magnétique SDH comportant une boucle dont le diamètre ou surface d'analyse, est supérieur à l'espacement d1 entre les deux lignes métalliques LMG1 et LMD1 d'une paire, pour détecter et déterminer l'intensité du champ magnétique créé par la circulation des courants transitoires dans les deux lignes métalliques.

Typiquement, l'espacement d1 est par exemple de l'ordre de 10 microns tandis que le diamètre de la boucle de la sonde magnétique SDH est de l'ordre de 50 microns.

La configuration illustrée sur la figure 3 est celle dans laquelle, en réponse à des signaux de tension impulsionnels, les courants transitoires circulent en sens inverse dans les deux lignes LMG1 et LMD1. La circulation de ces courants transitoires crée un champ électromagnétique dont on a représenté sur la partie droite de la figure 3 les lignes de champ de la composante magnétique de ce champ.

Puisque les deux courants transitoires circulent en sens inverses, on voit que l'intensité du champ magnétique présente un pic PCU entre les deux lignes métalliques. Ce pic PCU est supérieur à un seuil S prédéterminé. Le fait que l'intensité du champ magnétique dépasse le seuil S est alors représentatif par exemple de la valeur logique 1 du bit du code d'identification associé à cette paire de lignes métalliques.

Le champ magnétique créé par la paire de lignes formant antenne dépend de l'intensité du courant transitoire circulant dans cette antenne et décroît avec la distance par rapport à l'antenne. Par ailleurs, la boucle de la sonde SDH forme également une antenne qui, en fonction de sa dimension va être accordée sur l'antenne formée par les deux lignes métalliques à une certaine fréquence.

En général, cette fréquence pourra être par exemple comprise entre 10 kHz et 135 kHz conduisant à une détection du type « champ proche » (near field) par couplage inductif avec une portée de l'ordre de quelques dizaines de centimètres.

A titre indicatif, le courant circulant dans les lignes métalliques peut être de l'ordre du milliampère.

Bien qu'en général il soit suffisant de prévoir pour chaque moyen électriquement conducteur de la paire, une seule ligne métallique, il peut être particulièrement avantageux, de façon en particulier à augmenter l'intensité du champ magnétique, de prévoir que chaque moyen électriquement conducteur de ladite paire comporte non pas une ligne métallique mais plusieurs lignes métalliques de préférence parallèles LMG1-LMG10 ou LMD1-LMD10. Dans ce cas, toutes les lignes métalliques LMG1-LMG10 du même moyen électriquement conducteur sont parcourues par un courant transitoire de même sens.

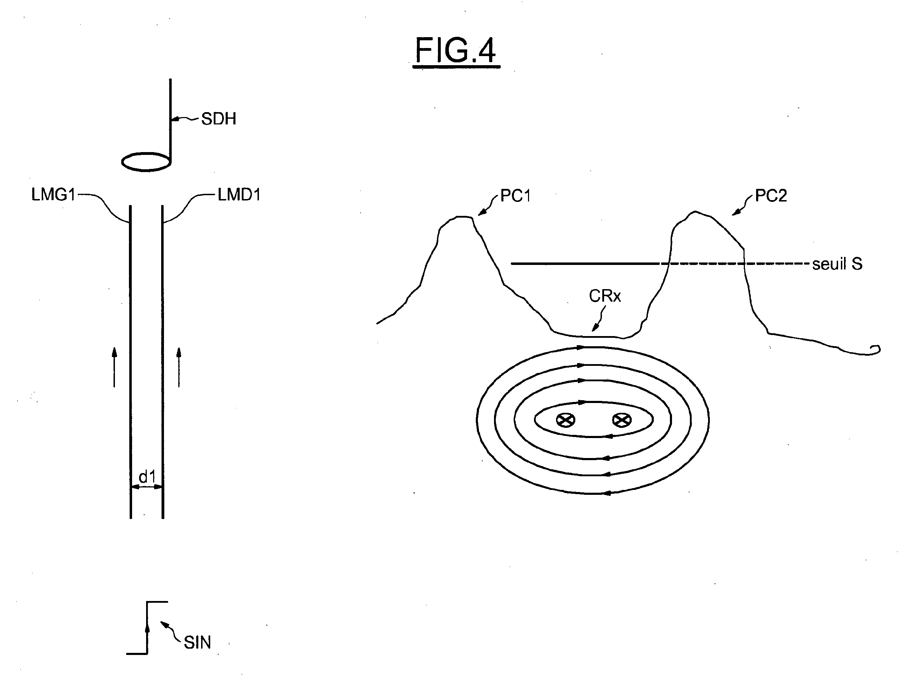

Sur la figure 4, on a illustré la configuration dans laquelle les deux lignes métalliques LMG1 et LMD1 de la paire de lignes métalliques sont parcourues par un courant transitoire de même sens. Dans ce cas, comme illustré sur la partie droite de la figure 4, l'intensité du champ magnétique présente deux pics PC1 et PC2 au-delà du seuil S. Ces deux pics PC1 et PC2 sont séparés par un creux CRX se situant en deçà du seuil S et situé approximativement entre les deux lignes métalliques LMG1 et LMD1.

La détection d'un creux entre deux pics permet ainsi de repérer une telle configuration qui est par exemple représentative de la valeur logique « 0 » du bit associé à ladite paire de lignes métalliques.

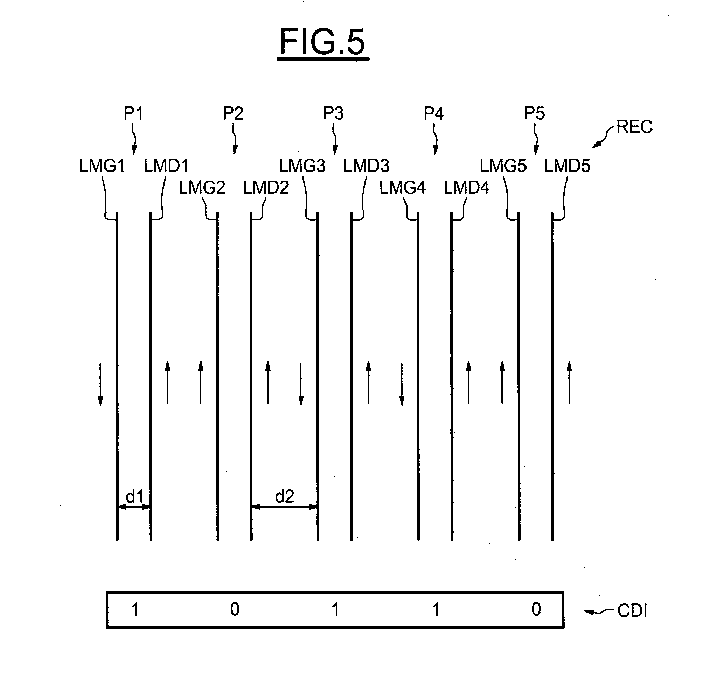

La figure 5 illustre le cas où le réseau électriquement conducteur comporte plusieurs paires de lignes métalliques P1-P5.

Dans cet exemple, le code d'identification CDI stocké dans le moyen de mémoire non volatil NVM comporte cinq bits dont les valeurs sont illustrées sur la figure 5. Ces valeurs déterminent donc les sens des courants dans les différentes lignes métalliques.

Par ailleurs, deux paires de lignes adjacentes Pi et Pi+1 sont espacées d'une distance supérieure à la surface d'analyse de la sonde magnétique, cet espacement d2 étant par exemple de l'ordre de la centaine de microns.

Pour procéder à l'identification du circuit intégré, on alimente le réseau REC avec des signaux de test, typiquement des transitions de tension, et on déplace la sonde magnétique au dessus du réseau électriquement conducteur REC et on analyse le champ magnétique. Et, si l'on retrouve des caractéristiques du champ magnétique (pics et creux) correspondant à la valeur du mot numérique 1 0 1 1 0 stocké en mémoire, le circuit intégré sera considéré comme ayant été identifié.

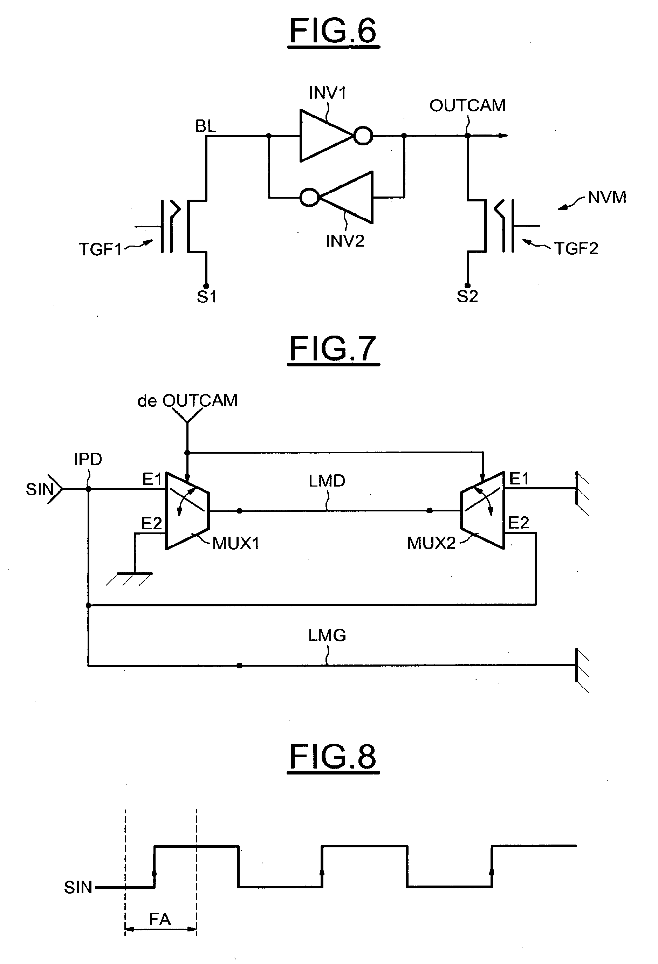

La figure 6 illustre un exemple de réalisation d'un moyen de mémoire non volatile NVM du type adressable par le contenu « Content Adressable Memory » (« CAM » selon un acronyme anglosaxon bien connu de l'homme du métier).

Plus précisément, la mémoire NVM du type adressable par le contenu comporte, par bit stocké, deux points-mémoires du type EEPROM connectés par deux inverseurs INV1 et INV2 montés tête-bêche.

Chaque point-mémoire EEPROM comporte un transistor à grille flottante TGF1, TGF2 dont les sources S1 et S2 sont reliées à la masse.

Lorsqu'au moment de la personnalisation électrique du circuit intégré, le point-mémoire de gauche de la cellule de la figure 6 est programmé tandis que le point-mémoire de droite de cette cellule est effacé, on considère que la cellule stocke par exemple un « 1 » logique.

En effet, après une précharge du noeud BL avec la tension d'alimentation Vdd puis relâchement de la précharge, le transistor TGF1 sera passant tandis que le transistor TGF12 sera bloqué, conduisant à la délivrance d'un « 1 » à la sortie OUTCAM.

Par contre, si les deux points-mémoires ont été effacés lors du stockage du code d'identification, cela correspond au stockage d'un « 0 » logique. En effet, après une précharge du noeud BL avec la tension d'alimentation Vdd puis relâchement de la précharge, un « 0 » logique sera délivré.

Une telle structure présente l'avantage de délivrer le contenu de la mémoire pour autant qu'une tension soit disponible, et ce même si le reste du circuit intégré est totalement endommagé.

La figure 7 illustre un exemple de moyens de contrôle MCTL permettant de générer les courants dans un sens ou dans l'autre dans les deux lignes LMG et LMD d'une paire de lignes métalliques.

Plus précisément, dans cet exemple non limitatif, l'une des lignes métalliques de la paire, par exemple la ligne LMD, est connectée entre les sorties de deux multiplexeurs MUX1 et MUX2. L'entrée de commande de chaque multiplexeur est connectée à la sortie OUTCAM de la cellule-mémoire associée à cette paire de lignes métalliques.

La première entrée du multiplexeur MUX1 est susceptible de recevoir le signal de test SIN qui, comme illustré sur la figure 8, est un signal de tension 0-5 volts par exemple, en forme de créneau.

La deuxième entrée E2 du multiplexeur MUX2 est également susceptible de recevoir ce signal SIN.

Les entrées E2 et E1 des multiplexeurs MUX1 et MUX2 sont par ailleurs reliés à la masse.

L'autre ligne métallique, par exemple la ligne LMG, est susceptible de recevoir à une de ses extrémités le signal SIN et a son autre extrémité reliée à la masse.

Ainsi, dans le cas où les deux multiplexeurs MUX1 et MUX2 sont placés sur leur première entrée E1, les deux lignes LMD et LMG sont parcourues par des courants transitoires de même sens.

Par contre, lorsque les deux multiplexeurs MUX1 et MUX2 sont placés sur leur entrée E2, les deux lignes métalliques sont parcourues par des courants transitoires de sens opposés.

La détection et l'analyse du champ magnétique sont effectuées au cours de fenêtres d'analyse FA englobant chaque transition montante du signal SIN.

En variante il serait possible de supprimer le multiplexeur MUX2 et de laisser l'extrémité de la ligne LMD en l'air. Par ailleurs la deuxième entrée E2 du multiplexeur MUX1 serait reliée à la borne IPD par l'intermédiaire d'un inverseur.

Dans ce cas, si le multiplexeur MUX1 est placé sur son entrée E1, la transition positive de SIN pendant la fenêtre d'analyse FA charge la ligne LMD qui est à la fois résistive et capacitive et provoque la circulation d'un courant transitoire de la gauche vers la droite. Bien entendu l'intensité du courant est la plus forte au voisinage de la sortie du multiplexeur produisant un champ magnétique plus intense dans cette zone.

Si le multiplexeur MUX1 est placé sur son entrée E2, la transition négative de l'opposé du signal SIN pendant la fenêtre d'analyse FA décharge la ligne LMD et provoque la circulation d'un courant transitoire de la droite vers la gauche.

Dans cette variante ce qui vient d'être décrit pour la ligne LMD est valable pour chaque ligne.

Cette variante présente l'avantage d'offrir une consommation électrique moindre.

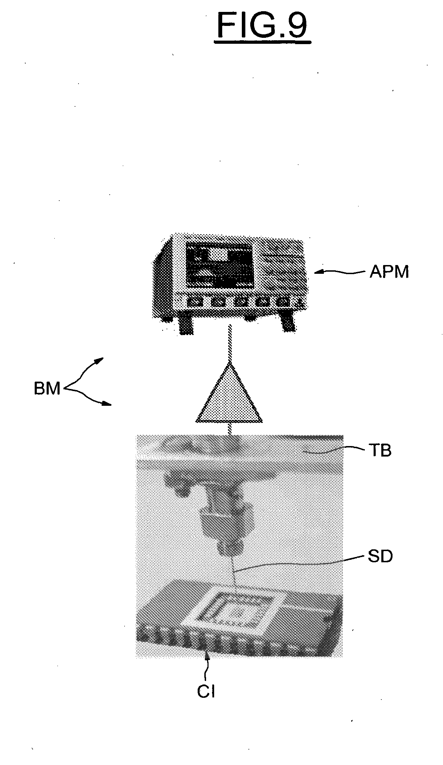

En pratique, comme illustré sur la figure 9, le banc de mesure BM comporte une table TB sur laquelle peut se déplacer la sonde SD, elle-même reliée à un appareil de mesure APM, par exemple un oscilloscope.

Plusieurs possibilités sont offertes. Il est possible, puisque l'on connaît l'emplacement du réseau électriquement conducteur REC dans le circuit intégré, de positionner la sonde SD au dessus du réseau électriquement conducteur et de la déplacer au dessus des paires de lignes en effectuant dans chaque fenêtre d'analyse FA la mesure du champ magnétique.

En variante, il serait possible d'effectuer sur un produit fabriqué et personnalisé une cartographie du champ magnétique comportant en particulier la partie relative au code d'identification, et d'effectuer à nouveau un balayage complet de la surface du circuit intégré lors d'une procédure d'identification, de façon à obtenir une nouvelle cartographie. La comparaison des deux cartographies, incluant la comparaison dans la zone relative au code d'identification, permettant alors l'identification ou non du circuit intégré.

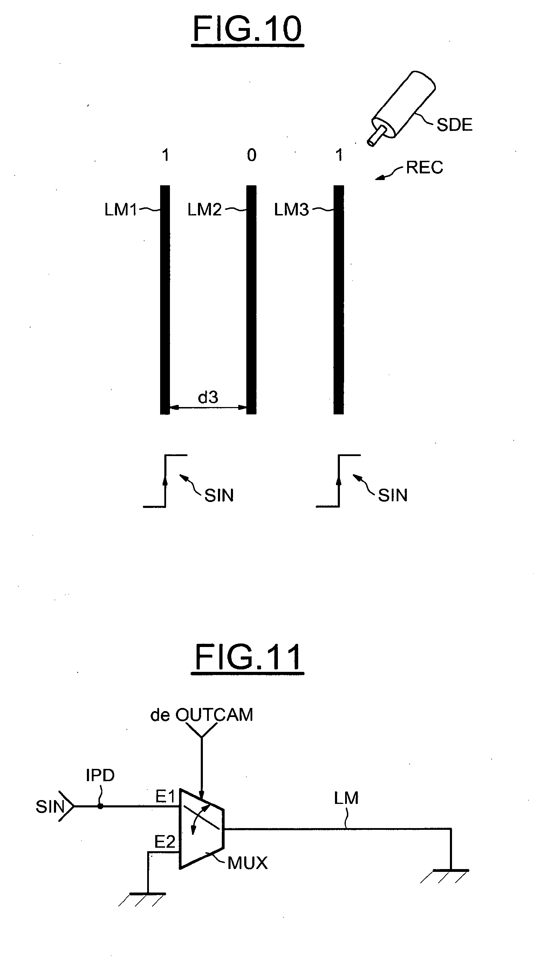

La figure 10 illustre une autre variante possible de l'invention.

Dans cet exemple, le réseau électriquement conducteur comporte plusieurs lignes métalliques LM1, LM2, LM3 mutuellement espacées d'une distance d3.

Dans cette variante, on génère ou non une variation de tension ou tension transitoire dans une ligne métallique en fonction de la valeur du bit associé à cette ligne métallique.

Ainsi, par exemple, pour une valeur logique de bit égale à « 1 », on génèrera une variation de tension dans la ligne métallique tandis que l'on n'en génèrera pas si la valeur du bit est égale à « 0 ».

On détecte alors la présence du champ électrique généré en utilisant une sonde SDE qui va détecter un couplage capacitif ou non en fonction de la présence variation de tension dans la ligne métallique.

Là encore, la distance d3, par exemple quelques centaines de micromètres, est choisie bien supérieure à la surface d'analyse de la sonde SDE.

Des moyens de contrôle MCTL adaptés à cette variante sont illustrés sur la figure 11 à titre d'exemple non limitatif.

Plus précisément, un multiplexeur MUX est connecté à une extrémité de chaque ligne métallique, l'autre extrémité de cette ligne métallique étant connectée à la masse.

L'entrée de commande du multiplexeur est connectée à la sortie OUTCAM de la cellule-mémoire stockant le bit associé à cette ligne métallique.

La première entrée E1 du multiplexeur MUX est destinée à recevoir le signal d'entrée SIN tandis que la deuxième entrée E2 est reliée à la masse.

Selon la valeur du bit logique, le multiplexeur est commuté sur sa première entrée ou sur sa deuxième entrée, permettant de générer ou non une variation de tension dans la ligne métallique.

Là encore, en variante il serait possible de laisser en l'air l'extrémité droite de la ligne LM de façon à réduire la consommation électrique.

## Revendications

1. Procédé d'identification d'un circuit intégré, comprenant une production d'un champ électromagnétique par un réseau électriquement conducteur (REC) réalisé au sein du circuit intégré (CI) et parcouru par des courants électriques transitoires ou soumis à des tensions transitoires dont les caractéristiques dépendent de la valeur d'un mot numérique formant un code d'identification (CDI) du circuit intégré et stocké de façon secrète dans une mémoire non volatile (NVM) du circuit intégré, et une analyse du champ électromagnétique produit de façon à retrouver ou non ledit code d'identification (CDI).

2. Procédé selon la revendication 1, dans lequel le réseau électriquement conducteur (REC) comporte au moins une paire (P1) de moyens électriquement conducteurs (LMD1, LMG1) associée à un bit du mot numérique, les caractéristiques des courants transitoires comportant le sens de circulation du courant transitoire dans un moyen électriquement conducteur, et on fait circuler dans les deux moyens électriquement conducteurs (LMD1, LMG1) deux courants transitoires de même sens ou de sens opposé en fonction de la valeur du bit, et on analyse le champ magnétique produit au dessus de chacun des moyens électriquement conducteurs et entre les deux moyens électriquement conducteurs.

3. Procédé selon la revendication 2, dans lequel le réseau électriquement conducteur comporte plusieurs paires (P1-P5) de moyens électriquement conducteurs mutuellement espacées d'une distance (d2) supérieure à la surface d'analyse d'un moyen d'analyse de champ magnétique, chaque paire (P1-P5) étant associée à un bit du mot numérique, et on fait circuler dans les deux moyens électriquement conducteurs de chaque paire deux courants transitoires de même sens ou de sens opposé en fonction de la valeur du bit associé à ladite paire, et on analyse le champ magnétique produit au dessus de chacun des moyens électriquement conducteurs et entre les deux moyens électriquement conducteur de chaque paire, avec ledit moyen d'analyse (SDH).

4. Procédé selon la revendication 2 ou 3, dans lequel les deux moyens électriquement conducteurs de chaque paire comporte respectivement deux lignes électriquement conductrices parallèles (LMD, LMG).

5. Procédé selon la revendication 2 ou 3, dans lequel chaque moyen électriquement conducteur comporte au moins deux lignes électriquement conductrices parallèles (LMD1, LMD10), et on fait circuler dans toutes les lignes (LMD1, LMD10) d'un moyen électriquement conducteur des courants transitoires dans le même sens.

6. Procédé selon la revendication 1, dans lequel le réseau électriquement conducteur (REC) comporte au moins un moyen élactriquement conducteur (LM1) associé à un bit du mot numérique, les caractéristiques des tensions transitoires comportant une génération ou une absence de génération d'une variation de tension dans le moyen électriquement conducteur, et on génère ou non dans le moyen électriquement conducteur une variation de tension en fonction de la valeur du bit, et on détecte la présence éventuelle d'un champ électrique produit au dessus du moyen électriquement conducteur.

7. Procédé selon la revendication 6, dans lequel le réseau électriquement conducteur (REC) comporte plusieurs moyens électriquement conducteurs (LM1-LM3) mutuellement espacés d'une distance (d3) supérieure à la surface d'analyse d'un moyen d'analyse de champ électrique (SDE), chaque moyen électriquement conducteur étant associé à un bit du mot numérique, et on génère ou non dans chaque moyen électriquement conducteur une variation de tension en fonction de la valeur du bit qui lui est associé, et on détecte la présence éventuelle d'un champ électrique produit au dessus de chaque moyen électriquement conducteur.

8. Procédé selon la revendication 6 ou 7, dans lequel chaque moyen électriquement conducteur (LM1-LM3) est une ligne électriquement conductrice.

9. Procédé selon l'une des revendications précédentes, dans lequel la mémoire non volatile (NVM) est une mémoire morte de type électriquement programmable et effaçable.

10. Circuit intégré, comprenant un moyen de stockage (NVM) non volatil configuré pour stocker de façon secrète un mot numérique dont la valeur forme un code d'identification (CDI) du circuit intégré, un réseau électriquement conducteur (REC) configuré pour être parcouru par des courants électriques transitoires de façon à générer un champ électromagnétique et comportant au moins une paire de moyens électriquement conducteurs (LMD1, LMG1) associée à un bit du mot numérique, et des moyens de contrôle (MCTL) configurés pour recevoir le mot numérique, générer lesdits courants électriques transitoires et définir le sens de circulation du courant transitoire dans chaque moyen électriquement conducteur en fonction de la valeur dudit bit.

11. Circuit selon la revendication 10, dans lequel le réseau électriquement conducteur comporte plusieurs paires (P1-P5) de moyens électriquement conducteurs mutuellement espacées d'une distance supérieure à la surface d'analyse d'un moyen d'analyse de champ magnétique, chaque paire étant associée à un bit du mot numérique, les moyens de contrôle (MCTL) étant configurés pour faire circuler dans les deux moyens électriquement conducteurs de chaque paire deux courants transitoires de même sens ou de sens opposé en fonction de la valeur du bit associé à ladite paire.

12. Circuit selon la revendication 10 ou 11, dans lequel les deux moyens électriquement conducteurs de chaque paire comporte respectivement deux lignes électriquement conductrices parallèles (LMD1, LMG1).

13. Circuit selon la revendication 10 ou 11, dans lequel chaque moyen électriquement conducteur comporte au moins deux lignes électriquement conductrices parallèles (LMD1, LMD10), et les moyens de contrôle (MCTL) sont configurés pour faire circuler dans toutes les lignes d'un moyen électriquement conducteur des courants transitoires dans le même sens.

14. Circuit intégré, comprenant un moyen de stockage (NVM) non volatil configuré pour stocker de façon secrète un mot numérique dont la valeur forme un code d'identification (CDI) du circuit intégré, un réseau électriquement conducteur (REC) configuré pour recevoir des variations de tensions de façon à générer un champ électromagnétique et comportant plusieurs moyens électriquement conducteurs (LM1-LM3) mutuellement espacés d'une distance (d3) supérieure à la surface d'analyse d'un moyen d'analyse de champ électrique, chaque moyen électriquement conducteur étant associé à un bit du mot numérique, et des moyens de contrôle (MCTL) configurés pour recevoir le mot numérique et pour générer ou non dans chaque moyen électriquement conducteur une variation de tension en fonction de la valeur du bit qui lui est associé.

15. Circuit selon la revendication 14, dans lequel chaque moyen électriquement conducteur est une ligne électriquement conductrice.

16. Circuit selon l'une des revendications 10 à 15, dans lequel le réseau électriquement conducteur (REC) est incorporé dans au moins un niveau de métallisation (Mn) de la partie d'interconnexion du circuit intégré.

17. Circuit selon l'une des revendications 10 à 16, dans lequel le moyen de stockage non volatil (NVM) comprend une mémoire morte de type électriquement programmable et effaçable.

18. Circuit selon l'une des revendications 10 à 16, dans lequel le moyen de stockage non volatil (NVM) comprend une mémoire du type adressable par le contenu comportant, par bit stocké, deux points-mémoires du type EEPROM connectés par deux inverseurs montés tête-bêche.

19. Circuit selon l'une des revendications 10 à 18, dans lequel les moyens de contrôle (MCTL) comportent au moins un multiplexeur dont la sortie est connectée à au moins une extrémité d'au moins un moyen électriquement conducteur, commandé par la valeur du bit associé à ce moyen électriquement conducteur, et possédant une première entrée destinée à recevoir un signal de tension (SIN) comportant au moins un créneau de tension.

## Patentansprüche

1. Verfahren zur Identifizierung einer integrierten Schaltung, das eine Erzeugung eines elektromagnetischen Felds durch ein elektrisch leitendes Netz (REC), das innerhalb der integrierten Schaltung (CI) realisiert ist und von transienten elektrischen Strömen durchflossen wird oder transienten Spannungen ausgesetzt ist, deren Kennlinien vom Wert eines Digitalworts abhängen, das einen Identifikationscode (CDI) der integrierten Schaltung formt und geheim in einem nicht-flüchtigen Speicher (NVM) der integrierten Schaltung gespeichert ist, und eine Analyse des erzeugten elektromagnetischen Felds enthält, um den Identifikationscode (CDI) wiederzufinden oder nicht.

2. Verfahren nach Anspruch 1, wobei das elektrisch leitende Netz (REC) mindestens ein Paar (P1) von elektrisch leitenden Einrichtungen (LMD1, LMG1) aufweist, das einem Bit des Digitalworts zugeordnet ist, wobei die Kennlinien der transienten Ströme die Fließrichtung des transienten Stroms in einer elektrisch leitenden Einrichtung aufweisen, und in den zwei elektrisch leitenden Einrichtungen (LMD1, LMG1) zwei transiente Ströme gleicher Richtung oder entgegengesetzter Richtung abhängig vom Wert des Bits fließen gelassen werden, und das über jeder der elektrisch leitenden Einrichtungen und zwischen den zwei elektrisch leitenden Einrichtungen erzeugte Magnetfeld analysiert wird.

3. Verfahren nach Anspruch 2, wobei das elektrisch leitende Netz mehrere Paare (P1-P5) von elektrisch leitenden Einrichtungen aufweist, die zueinander einen Abstand (d2) größer als die Analysefläche einer Magnetfeld-Analyseeinrichtung haben, wobei jedes Paar (P1-P5) einem Bit des Digitalworts zugeordnet ist, und in den zwei elektrisch leitenden Einrichtungen jedes Paars zwei transiente Ströme gleicher Richtung oder entgegengesetzter Richtung abhängig vom Wert des dem Paar zugeordneten Bits fließen gelassen werden, und das über jeder der elektrisch leitenden Einrichtungen und zwischen den zwei elektrisch leitenden Einrichtungen jedes Paars erzeugte Magnetfeld mit der Analyseeinrichtung (SDH) analysiert wird.

4. Verfahren nach Anspruch 2 oder 3, wobei die zwei elektrisch leitenden Einrichtungen jedes Paars je zwei parallele elektrisch leitende Leitungen (LMD, LMG) aufweisen.

5. Verfahren nach Anspruch 2 oder 3, wobei jede elektrisch leitende Einrichtung mindestens zwei parallele elektrisch leitende Leitungen (LMD1, LMD10) aufweist, und in allen Leitungen (LMD1, LMD10) einer elektrisch leitenden Einrichtung transiente Ströme in gleicher Richtung fließen gelassen werden.

6. Verfahren nach Anspruch 1, wobei das elektrisch leitende Netz (REC) mindestens eine elektrisch leitende Einrichtung (LM1) aufweist, die einem Bit des Digitalworts zugeordnet ist, wobei die Kennlinien der transienten Spannungen eine Erzeugung oder eine Erzeugungsabwesenheit einer Spannungsänderung in der elektrisch leitenden Einrichtung aufweisen, und in der elektrisch leitenden Einrichtung abhängig vom Wert des Bits eine Spannungsänderung erzeugt wird oder nicht, und das mögliche Vorhandensein eines über der elektrisch leitenden Einrichtung erzeugten elektrischen Felds erfasst wird.

7. Verfahren nach Anspruch 6, wobei das elektrisch leitende Netz (REC) mehrere elektrisch leitende Einrichtungen (LM1-LM3) aufweist, die zueinander einen Abstand (d3) größer als die Analysefläche einer Analyseeinrichtung eines elektrischen Felds (SDE) haben, wobei jede elektrisch leitende Einrichtung einem Bit des Digitalworts zugeordnet ist, und in jeder elektrisch leitenden Einrichtung abhängig vom Wert des ihr zugeordneten Bits eine Spannungsänderung erzeugt wird oder nicht, und das mögliche Vorhandensein eines über jeder elektrisch leitenden Einrichtung erzeugten elektrischen Felds erfasst wird.

8. Verfahren nach Anspruch 6 oder 7, wobei jede elektrisch leitende Einrichtung (LM1-LM3) eine elektrisch leitende Leitung ist.

9. Verfahren nach einem der vorhergehenden Ansprüche, wobei der nicht-flüchtige Speicher (NVM) ein Festspeicher vom elektrisch programmierbaren und löschbaren Typ ist.

10. Integrierte Schaltung, die eine nicht-flüchtige Speichereinrichtung (NVM), die zum geheimen Speichern eines Digitalworts konfiguriert ist, dessen Wert einen Identifikationscode (CDI) der integrierten Schaltung bildet, ein elektrisch leitende Netz (REC), das konfiguriert ist, von transienten elektrischen Strömen durchflossen zu werden, um ein elektromagnetisches Feld zu erzeugen und mindestens ein Paar elektrisch leitender Einrichtungen (LMD1, LMG1) aufweist, das einem Bit des Digitalworts zugeordnet ist, und Steuereinrichtungen (MCTL) enthält, die konfiguriert sind, das Digitalwort zu empfangen, die transienten elektrischen Ströme zu erzeugen und die Fließrichtung des transienten Stroms in jeder elektrisch leitenden Einrichtung abhängig vom Wert des Bits zu definieren.

11. Schaltung nach Anspruch 10, wobei das elektrisch leitende Netz mehrere Paare (P1-P5) von elektrisch leitenden Einrichtungen aufweist, die zueinander einen größeren Abstand als die Analysefläche einer Magnetfeld-Analyseeinrichtung haben, wobei jedes Paar einem Bit des Digitalworts zugeordnet ist, wobei die Steuereinrichtungen (MCTL) konfiguriert sind, in den zwei elektrisch leitenden Einrichtungen jedes Paars zwei transiente Ströme gleicher Richtung oder entgegengesetzter Richtung abhängig vom Wert des dem Paar zugeordneten Bits fließen zu lassen.

12. Schaltung nach Anspruch 10 oder 11, wobei die zwei elektrisch leitenden Einrichtungen jedes Paars je zwei parallele elektrisch leitende Leitungen (LMD1, LMG1) aufweisen.

13. Schaltung nach Anspruch 10 oder 11, wobei jede elektrisch leitende Einrichtung mindestens zwei parallele elektrisch leitende Leitungen (LMD1, LMD10) aufweist, und die Steuereinrichtungen (MCTL) konfiguriert sind, in allen Leitungen einer elektrisch leitenden Einrichtung transiente Ströme in der gleichen Richtung fließen zu lassen.

14. Integrierte Schaltung, die eine nicht-flüchtige Speichereinrichtung (NVM), die konfiguriert ist, geheim ein Digitalwort zu speichern, dessen Wert einen Identifikationscode (CDI) der integrierten Schaltung bildet, ein elektrisch leitendes Netz (REC), das konfiguriert ist, Änderungen von Spannungen zu empfangen, um ein elektromagnetisches Feld zu erzeugen, und mehrere elektrisch leitende Einrichtungen (LM1-LM3) aufweist, die einen Abstand (d3) zueinander haben, der größer ist als die Analysefläche einer Analyseeinrichtung eines elektrischen Felds, wobei jede elektrisch leitende Einrichtung einem Bit des Digitalworts zugeordnet ist, und Steuereinrichtungen (MCTL) enthält, die konfiguriert sind, das Digitalwort zu empfangen und in jeder elektrisch leitenden Einrichtung eine Spannungsänderung abhängig vom Wert des ihr zugeordneten Bits zu erzeugen oder nicht.

15. Schaltung nach Anspruch 14, wobei jede elektrisch leitende Einrichtung eine elektrisch leitende Leitung ist.

16. Schaltung nach einem der Ansprüche 10 bis 15, wobei das elektrisch leitende Netz (REC) in mindestens einen Metallisierungsbereich (Mn) des Verbindungsteils der integrierten Schaltung eingebaut ist.

17. Schaltung nach einem der Ansprüche 10 bis 16, wobei die nicht-flüchtige Speichereinrichtung (NVM) einen Festspeicher vom elektrisch programmierbaren und löschbaren Typ enthält.

18. Schaltung nach einem der Ansprüche 10 bis 16, wobei die nicht-flüchtige Speichereinrichtung (NVM) einen Speicher von dem vom Inhalt adressierbaren Typ enthält, der pro gespeichertem Bit zwei Speicherpunkte des Typs EEPROM aufweist, die durch zwei Kopf bei Fuß montierte Wechselschalter verbunden sind.

19. Schaltung nach einem der Ansprüche 10 bis 18, wobei die Steuereinrichtungen (MCTL) mindestens einen Multiplexer aufweisen, dessen Ausgang mit mindestens einem Ende mindestens einer elektrisch leitenden Einrichtung verbunden ist, gesteuert durch den Wert des dieser elektrisch leitenden Einrichtung zugeordneten Bits, und der einen ersten Eingang besitzt, der dazu bestimmt ist, ein Spannungssignal (SIN) zu empfangen, das mindestens eine Spannungsspitze aufweist.

## Claims

1. Process for identifying an integrated circuit, comprising a production of an electromagnetic field by an electrically conductive network (REC) produced within the integrated circuit (CI) and passed through by transient electrical currents or subjected to transient voltages, the characteristics of which depend on the value of a digital word forming an identification code (CDI) of the integrated circuit and stored secretly in a non-volatile memory (NVM) of the integrated circuit, and an analysis of the electromagnetic field produced so as to recognize or not recognize said identification code (CDI).

2. Process according to Claim 1, in which the electrically conductive network (REC) comprises at least one pair (PI) of electrically conductive means (LMD1, LMG1) associated with a bit of the digital word, the characteristics of the transient currents comprising the direction of flow of the transient current in an electrically conductive means, and two transient currents are made to flow in the two electrically conductive means (LMD1, LMG1) in the same direction or in opposite directions according to the value of the bit, and the magnetic field produced over each of the electrically conductive means and between the two electrically conductive means is analyzed.

3. Process according to Claim 2, in which the electrically conductive network comprises a plurality of pairs (P1-P5) of electrically conductive means mutually spaced apart by a distance (d2) greater than the analysis surface area of a magnetic field analysis means, each pair (P1-P5) being associated with a bit of the digital word, and two transient currents are made to flow in the two electrically conductive means of each pair in the same direction or in opposite directions according to the value of the bit associated with said pair, and the magnetic field produced over each of the electrically conductive means and between the two electrically conductive means of each pair is analyzed, with said analysis means (SDH).

4. Process according to Claim 2 or 3, in which the two electrically conductive means of each pair respectively comprise two parallel electrically conductive lines (LMD, LMG).

5. Process according to Claim 2 or 3, in which each electrically conductive means comprises at least two parallel electrically conductive lines (LMD1, LMD10), and transient currents are made to flow in the same direction in all the lines (LMD1, LMD10) of an electrically conductive means.

6. Process according to Claim 1, in which the electrically conductive network (REC) comprises at least one electrically conductive means (LM1) associated with a bit of the digital word, the characteristics of the transient voltages comprising a generation or an absence of generation of a voltage variation in the electrically conductive means, and a voltage variation is generated or not generated in the electrically conductive means according to the value of the bit, and the possible presence of an electrical field produced over the electrically conductive means is detected.

7. Process according to Claim 6, in which the electrically conductive network (REC) comprises a plurality of electrically conductive means (LMI-LM3) mutually spaced apart by a distance (d3) greater than the analysis surface area of an electrical field analysis means (SDE), each electrically conductive means being associated with a bit of the digital word, and a voltage variation is generated or not generated in each electrically conductive means according to the value of the bit which is associated with it, and the possible presence of an electrical field produced over each electrically conductive means is detected.

8. Process according to Claim 6 or 7, in which each electrically conductive means (LM1-LM3) is an electrically conductive line.

9. Process according to one of the preceding claims, in which the non-volatile memory (NVM) is a read-only memory of electrically programmable and erasable type.

10. Integrated circuit, comprising a non-volatile storage means (NVM) configured to secretly store a digital word, the value of which forms an identification code (CDI) of the integrated circuit, an electrically conductive network (REC) configured to be passed through by transient electrical currents so as to generate an electromagnetic field and comprising at least one pair of electrically conductive means (LMD1, LMG1) associated with a bit of the digital word, and control means (MCTL) configured to receive the digital word, generate said transient electrical currents and define the direction of flow of the transient current in each electrically conductive means according to the value of said bit.

11. Circuit according to Claim 10, in which the electrically conductive network comprises a plurality of pairs (P1-P5) of electrically conductive means mutually spaced apart by a distance greater than the analysis surface area of a magnetic field analysis means, each pair being associated with a bit of the digital word, the control means (MCTL) being configured to make two transient currents flow in the two electrically conductive means of each pair in the same direction or in opposite directions according to the value of the bit associated with said pair.

12. Circuit according to Claim 10 or 11, in which the two electrically conductive means of each pair respectively comprise two parallel electrically conductive lines (LMD1, LMG1).

13. Circuit according to Claim 10 or 11, in which each electrically conductive means comprises at least two parallel electrically conductive lines (LMD1, LMD10), and the control means (MCTL) are configured to make transient currents flow in the same direction in all the lines of an electrically conductive means.

14. Integrated circuit, comprising a non-volatile storage means (NVM) configured to secretly store a digital word, the value of which forms an identification code (CDI) of the integrated circuit, an electrically conductive network (REC) configured to receive voltage variations so as to generate an electromagnetic field and comprising a plurality of electrically conductive means (LM1-LM3) mutually spaced apart by a distance (d3) greater than the analysis surface area of an electrical field analysis means, each electrically conductive means being associated with a bit of the digital word, and control means (MCTL) configured to receive the digital word and to generate or not generate a voltage variation in each electrically conductive means according to the value of the bit which is associated with it.

15. Circuit according to Claim 14, in which each electrically conductive means is an electrically conductive line.

16. Circuit according to one of Claim 10 to 15, in which the electrically conductive network (REC) is incorporated in at least one metallization level (Mn) of the interconnect part of the integrated circuit.

17. Circuit according to one of Claims 10 to 16, in which the non-volatile storage means (NVM) comprises a read-only memory of electrically programmable and erasable type.

18. Circuit according to one of Claims 10 to 16, in which the non-volatile storage means (NVM) comprises a memory of the type addressable by the content comprising, for each stored bit, two memory points of EEPROM type connected by two inverters mounted head-to-tail.

19. Circuit according to one of Claims 10 to 18, in which the control means (MCTL) comprise at least one multiplexer, the output of which is connected to at least one end of at least one electrically conductive means, controlled by the value of the bit associated with this electrically conductive means and having a first input intended to receive a voltage signal (SIN) comprising at least one voltage slot.
